# EUROPÄISCHE PATENTANMELDUNG

(11) **EP 1 657 745 A1**
(43) Veröffentlichungstag der Anmeldung: **17.05.2006**
(21) Anmeldenummer: 05024762.6
(22) Anmeldetag: 12.11.2005
(51) Int. Cl.: H01L 21/8222, H01L 27/082

(54) **Integrierte Schaltung und Verfahren zur Herstellung einer integrierten Schaltung auf einem Halbleiterplättchen**

(30) Priorität: 16.11.2004 DE 102004055213
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Integrierte Schaltung auf einem Halbleiterplättchen, mit
- einem ersten Bipolartransistor (Q1) und
- einem zweiten Bipolartransistor (Q2),
wobei
- der erste Bipolartransistor (Q1) einen ersten, durch zumindest eine Epitaxieschicht aufgewachsenen Kollektorbereich (1') eines ersten Leitungstyps aufweist, und
- der zweite Bipolartransistor (Q2) einen zweiten, durch diese Epitaxieschicht aufgewachsenen zweiten Kollektorbereich (1) dieses ersten Leitungstyps aufweist,
- der erste Kollektorbereich (1') eine erste Kollektordriftzone (12') und der zweite Kollektorbereich (1) eine zweite Kollektordriftzone (12) aufweist, und
- diese erste Kollektordriftzone (12') gegenüber dieser zweiten Kollektordriftzone (12) durch teilweises Ätzen der Epitaxieschicht verkürzt ist.

## Beschreibung

Die vorliegende Erfindung betrifft eine integrierte Schaltung und ein Verfahren zur Herstellung einer integrierten Schaltung auf einem Halbleiterplättchen.

In Halbleitertechnologien werden vertikale Bipolartransistoren unterschiedlicher Spannungsfestigkeit und Frequenztauglichkeit zur Verfügung gestellt. Hierbei steigt im Allgemeinen die Spannungsfestigkeit mit sinkender Kollektordotierung. Ebenfalls führt eine geringere Kollektordotierung zu einer geringeren Grenzfrequenz.

Insbesondere im Hochfrequenzbereich ist das Verfahren des selektiv implantierten Kollektors bekannt. Hierbei werden aus einer einheitlichen Kollektorepitaxie ein erstes und ein zweites Kollektorgebiet erzeugt, aus welchem ersten Kollektorgebiet der Kollektor eines ersten Bipolartransistors mit hoher Spannungsfestigkeit und geringerer Frequenztauglichkeit, und aus welchem zweiten Kollektorgebiet der Kollektor eines zweiten Bipolartransistors mit geringerer Spannungsfestigkeit und besserer Frequenztauglichkeit herausgebildet werden. Hierzu wird das zweite Kollektorgebiet örtlich begrenzt mit einer zusätzlichen Kollektorimplantation (siC - selectiv implanted collector) versehen. Durch diese selektive Kollektorimplantation wird die Dotierstoffkonzentration im zweiten Kollektorgebiet über die Dotierstoffkonzentration im ersten Kollektorgebiet angehoben.

pn-Übergänge in Halbleitern existieren insbesondere als "lange" oder als "kurze" Dioden. Bei einer "langen" p-n-n⁺-Diode endet die Raumladungszone bei Sperrspannungen, wie sie beim normalen Betriebsbedingungen an dem pn-Übergang anliegen, n-seitig im n-Gebiet, während sie bei "kurzen" Dioden auf das n⁺-Gebiet durchgreift. Durch den Durchgriff wird die Sperrfähigkeit "kurzer" Dioden gegenüber der Sperrfähigkeit einer "langen" Diode mit denselben Dotierstoffniveaus reduziert. Für einen Bipolartransistor mit gegebener Kollektor-Basis-Durchbruchsspannung ist daher eine bestimmte Ausdehnung der Kollektor-Driftzone nötig und erfordert mithin eine bestimmte Dicke der Kollektorepitaxie.

Umgekehrt ist insbesondere im Hochfrequenzbereich der Kollektorwiderstand ein wesentliches Kriterium für die Qualität des Bipolartransistors. Ein Teil des Kollektorwiderstandes ist der Widerstand eines eventuellen, unter normalen Betriebsbedingungen nicht ausgeräumten Anteils der Kollektor-Driftzone. Durch eine hinreichend hohe selektive Kollektorimplantation wird im Allgemeinen die Ausdehnung der Kollektor-Raumladungszone bei der gewünschten Betriebsbedingung reduziert. Da man bei Festlegung der Dicke der Kollektorepitaxie auf die Bedürfnisse bei dem höher sperrenden Transistor Rücksicht nehmen muss, wird häufig das zweite Kollektorgebiet im Betrieb des zweiten Bipolartransistors nicht vollständig ausgeräumt. Hierdurch wird der Kollektorwiderstand des zweiten Bipolartransistors nachteilig erhöht. Beispielsweise führen 120 nm nichtausgeräumter Kollektordriftzone mit einem üblichen Querschnitt von 20 x 0.6 µm² selbst bei der hohen Kollektordotierung von 1 e17 cm⁻³ noch zu einem zusätzlichen Kollektorwiderstand von 8 Ohm, was in vielen Fällen den Hauptteil des gesamten Kollektorwiderstandes ausmacht.

Im Hochfrequenzbereich werden die Transistoren zur Reduktion der Umladezeiten der Diffusionskapazitätsbeläge vorzugsweise bei hohen Stromdichten betrieben. Hierbei wird die Raumladungsdichte aufgrund der (im Falle eines npn-Transistors, p-geladenen) lonenrümpfe im ausgeräumten Teil der Kollektordriftzone durch die Raumladungsdichte der sich mit endlicher Geschwindigkeit durch die Raumladungszone bewegenden Elektronen zumindest teilweise kompensiert. Der kollektorseitige Rand der Raumladungszone wandert daher auf den Subkollektor zu. Im f_{T}-optimalen Arbeitspunkt trägt im Wesentlichen nur noch die Subkollektor-Flanke, nicht aber die Kollektordriftzone zum Kollektorwiderstand bei.

Bei einer Herstellung der genannten Kollektordriftzonen nach dem Stand der Technik wird auf eine hoch n-dotierte, monokristalline Siliziumschicht als Subkollektor eine ca. 190 nm dicke und mit 1 e17 cm⁻³ dotierte Silizium-Kollektorepitaxie aufgewachsen, wobei ein Dickenvorhalt von 20 nm dazu dient, die Ausdiffusion von Dotierstoff aus der hoch n-dotierten Siliziumschicht auszugleichen. Diese Epitaxieschicht stellt "wie gewachsen" die niederdotierte Kollektordriftzone dar.

Aufgabe der vorliegenden Erfindung ist es, ein Verfahren anzugeben, mit dem sich auf einem einzigen Halbleiterplättchen unterschiedliche Transistoren mit unterschiedlichen Kollektordriftzonen realisieren lassen, wobei innerhalb des Kollektorbereiches ein möglichst hoher vertikaler Konzentrationsgradient erzielt werden soll.

Diese Aufgabe wird erfindungsgemäß durch ein Verfahren mit den Merkmalen des Patentanspruches 1, durch eine integrierte Schaltung mit den Merkmalen des Patentanspruchs 14 und durch eine integrierte Kaskodenschaltung mit den Merkmalen des Patentanspruchs 19 gelöst. Vorteilhafte Weiterbildungen der Erfindung sind Gegenstand von Unteransprüchen.

Demzufolge werden in einem Verfahren zur Herstellung einer integrierten Schaltung auf einem Halbleiterplättchen ein erster Bipolartransistor mit einem ersten Kollektorbereich eines ersten Leitungstyps und ein zweiter Bipolartransistor mit einem zweiten Kollektorbereich dieses ersten Leitungstyps erzeugt. Der erste Leitungstyp ist dabei beispielsweise der n-Leitungstyp, wie dieser beispielsweise durch eine Phosphordotierung erzeugt werden kann.

Der erste Kollektorbereich und der zweite Kollektorbereich werden vorzugsweise durch zumindest eine Kollektorepitaxie aufgewachsen. Die Kollektoreptiaxie kann sich dabei aus einer einzigen oder mehreren Epitaxieschritten zusammensetzen. Weiterhin ist die Einbringung eines Dotierstoffprofils während der Epitaxie möglich.

Das Wesen der Erfindung liegt in dem Einbringen eines Ätzstopps in den ersten Kollektorbereich. Hingegen wird der zweite Kollektorbereich des zweiten Transistors nicht geätzt, so dass hier kein Ätzstopp benötigt wird, oder, sofern ein Ätzstopp vorhanden ist, dieser aufgrund der fehlenden Ätzung keine Wirkung entfaltet.

Durch eine Ätzung wird dieser erste Kollektorbereich verkürzt. Dies bewirkt, dass die Hochfrequenzeigenschaften der beiden Transistoren unterschiedlich sind. Der erste Transistor weist gegenüber dem zweiten Transistor dabei vorzugsweise eine höhere Transitfrequenz f_{T} und eine geringere Durchbruchspannung auf. Bei diesem erfindungsgemäßen Verfahren bleibt ein scharfer, epitaktisch erzeugter n⁻-n⁺-Übergang vorzugsweise erhalten.

Eine vorteilhafte erste Weiterbildungsvariante der Erfindung sieht vor, dass der Ätzstopp durch ein Dotierungsprofil in den ersten Kollektorbereich selektiv eingebracht wird. Beispielsweise kann für Silizium ein Ätzmittel verwendet werden, dass eine Mischung aus einem Teil Flusssäure, HF, drei Teilen Salpetersäure, HNO₃ und acht Teilen Ameisensäuse, CH₃COOH aufweist. Die genannte Ätzmischung ätzt Silizium mit einer Ätzrate von 0,01 µm pro Minute, wenn der spezifische Widerstand des Siliziums aufgrund seiner Dotierung weniger als etwa 0.01 Ohmcm beträgt, jedoch mit einer Ätzrate von 1 µm pro Minute bei einem spezifischen Widerstand von mehr als 0.1 Ohmcm. Die Ätzung kommt hiernach bei einer Dotierstoffkonzentration von etwa 5e17 cm⁻³ im Wesentlichen zum Stillstand.

Nach einer Bildung der dicken, niedrig dotierten Kollektordriftzone wird gemäß einer Ausgestaltung der Erfindung durch eine Implantation mittlerer Energie ein Bereich zwischen 100 nm und 170 nm Tiefe im Silizium auf eine Dotierstoffkonzentration von etwa 5e17 cm⁻³ gebracht, während durch zwei niederenergetische Implantationen das Siliziummaterial bis zu einer Tiefe von etwa 70 nm ausreichend hoch dotiert wird, um anschließend mit Hilfe der genannten Ätzmischung abgetragen zu werden.

Demnach sieht eine vorteilhafte Ausgestaltung vor, dass zum selektiven Einbringen des Dotierungsprofils eine Maske aufgebracht und Dotanden implantiert werden. Dabei bedeckt die Maske zumindest den Kollektorbereich des zweiten Transistors.

Die Erfindung weiterbildend wird während des Herstellungsverfahrens in den ersten Kollektorbereich ein Dotierungsprofil derart eingebracht, dass ein erstes Halbleitergebiet im ersten Kollektorbereich eine erste Dotierstoffkonzentration und in einem oberhalb des ersten Halbleitergebiets gelegenen zweiten Halbleitergebiet des ersten Kollektorbereichs eine zweite Dotierstoffkonzentration aufweist, wobei die zweite Dotierstoffkonzentration im zweiten Halbleitergebiet höher ist als die erste Dotierstoffkonzentration im ersten Halbleitergebiet.

Vorteilhafterweise wird das zweite Halbleitergebiet durch ein selektiv auf das hochdotierte zweite Halbleitergebiet wirkendes Ätzmittel im Wesentlichen bis zum ersten Halbleitergebiet geätzt, wobei die niedrige, erste Dotierstoffkonzentration des ersten Halbleitergebiets als Ätzstopp wirkt.

Zwei unterschiedliche, jedoch auch kombinierbare Ausgestaltungen sehen vor, dass vor und/oder nach dem Ätzen des zweiten Halbleitergebietes in das erste Halbleitergebiet Dotanden implantiert werden.

Eine andere, bevorzugte Weiterbildung der Erfindung sieht vor, dass während der Kollektorepitaxie eine Silizium-Germanium-Schicht eingebracht wird. Vorzugsweise wird der erste Kollektorbereich bis zur Silizium-Germanium-Schicht geätzt, indem für das verwendete Ätzmittel die Silizium-Germanium-Schicht als Ätzstopp wirkt.

In einer vorteilhaften Ausgestaltung der Erfindung ist zudem vorgesehen, dass nach dem Erreichen der Silizium-Germanium-Schicht durch den Ätzvorgang diese Silizium-Germanium-Schicht im ersten Kollektorbereich entfernt wird. Vor und/oder nach dem Entfernen können zudem Dotanden in die verbleibende Epitaxieschicht eingebracht werden.

Eine besonders vorteilhafte Ausgestaltung der Erfindung sieht vor, dass während der Kollektorepitaxie im ersten Kollektorbereich und im zweiten Kollektorbereich ein Dotierstoffkonzentrationsverlauf mit einem Konzentrationsgradienten größer 1e22 cm⁻⁴ erzeugt wird.

Nach einer selektiven Implantation von Dotanden in den Kollektorbereich des ersten Transistors ist vorteilhafterweise vorgesehen, dass eine minimale Dotierstoffkonzentration im ersten Kollektorbereich höher ist als die minimale Dotierstoffkonzentration im zweiten Kollektorbereich.

Eine besonders vorteilhafte Weiterbildung der Erfindung sieht vor, dass die Kollektorepitaxie zumindest teilweise eine laterale Festphasenepitaxie ist, wobei amorphes Silizium auf einer Silizidschicht und auf ein monokristallines Siliziumsubstrat aufgebracht und in einem Temperschritt ausgehend von dem als Kristallisationskeim wirkenden monokristallinem Siliziumsubstrat auskristallisiert wird. Zusätzlich kann zur Dotierung des Materials der Kollektorepitaxie die Silizidschicht mit einem derartigen Fremdstoff versehen sein, der nachfolgend in den ersten Kollektorbereich eindiffundiert wird und dort als Dotierstoff des ersten Leitungstyps wirkt.

Ein weiterer wesentlicher Aspekt der Erfindung ist eine integrierte Schaltung auf einem Halbleiterplättchen. Diese integriert Schaltung weist zumindest einen ersten Bipolartransistor und einen zweiten Bipolartransistor auf. Dabei weist der erste Bipolartransistor einen ersten, durch zumindest eine Epitaxieschicht aufgewachsenen Kollektorbereich eines ersten Leitungstyps und der zweite Bipolartransistor einen zweiten, durch diese Epitaxieschicht aufgewachsenen zweiten Kollektorbereich dieses ersten Leitungstyps auf.

Weiterhin weist der erste Kollektorbereich eine erste Kollektordriftzone und der zweite Kollektorbereich eine zweite Kollektordriftzone auf. Das Wesen der Erfindung besteht daher auch darin, das diese erste Kollektordriftzone gegenüber dieser zweiten Kollektordriftzone durch teilweises Ätzen der Epitaxieschicht verkürzt ist. Dies bewirkt, dass der erste Kollektorbereich eine erste Kollektordriftzone und der zweite Kollektorbereich eine zweite Kollektordriftzone aufweist, die im Wesentlichen durch die Dicke und die Dotierstoffkonzentration im Kollektorbereich bestimmt sind.

Vorteilhafterweise weist der erste Kollektorbereich eine höhere minimale Dotierstoffkonzentration auf als der zweite Kollektorbereich.

Vorzugsweise grenzt der erste Kollektorbereich unmittelbar an eine Silizium-Germanium-Schicht eines ersten Basisbereiches eines zweiten Leitungstyps des ersten Bipolartransistors und/oder der zweite Kollektorbereich grenzt unmittelbar an eine Silizium-Germanium-Schicht eines zweiten Basisbereiches des zweiten Leitungstyps des zweiten Bipolartransistors.

Gemäß einer besonders bevorzugten Weiterbildung der Erfindung grenzt innerhalb des ersten Kollektorbereichs und/oder innerhalb des zweiten Kollektorbereichs die Epitaxieschicht zumindest teilweise an eine Silizidschicht an, um einen niederohmigen Anschluss dieser Epitaxieschicht zu ermöglichen.

Die Erfindung vorteilhaft weiterbildend ist vorgesehen, dass der erste Kollektorbereich und/oder der zweite Kollektorbereich einen Dotierstoffkonzentrationsverlauf mit einem Konzentrationsgradienten größer als 1 e22 cm⁻⁴ aufweist.

Ein weiterer Aspekt der Erfindung ist eine Integrierte Hochfrequenz-Kaskodenschaltung mit einem ersten Bipolartransistor und einem zweiten Bipolartransistor. Dabei weist der erste Bipolartransistor einen ersten, durch zumindest eine Epitaxieschicht aufgewachsenen Kollektorbereich eines ersten Leitungstyps und der zweite Bipolartransistor einen zweiten, durch diese Epitaxieschicht aufgewachsenen zweiten Kollektorbereich dieses ersten Leitungstyps auf.

Der erste Kollektorbereich weist eine erste Kollektordriftzone und der zweite Kollektorbereich eine zweite Kollektordriftzone auf. Diese erste Kollektordriftzone ist gegenüber dieser zweiten Kollektordriftzone durch teilweises Ätzen der Epitaxieschicht verkürzt ist. Der zweite Kollektorbereich des zweiten Bipolartransistors ist mit einem ersten Emitterbereich des ersten Bipolartransistors elektrisch verbunden.

Im Folgenden wird die Erfindung anhand eines zeichnerisch dargestellten Ausführungsbeispiels näher erläutert.

### Dabei zeigen

- Fig. 1: eine schematische Schnittdarstellung durch einen ersten Bipolartransistor und durch einen zweiten Bipolartransistor,
- Fig. 2a: einen schematischen Dotierstoffverlauf entlang der Schnittlinie a,
- Fig. 2b: einen schematischen Dotierstoffverlauf entlang der Schnittlinie b,
- Fig. 3: einen schematischen Dotierstoffverlauf während eines Herstellungsverfahrensschrittes, und
- Fig. 4: einen schematischen Dotierstoffverlauf mit einer Silizium-Germanium-Schicht während eines Herstellungsverfahrensschrittes.

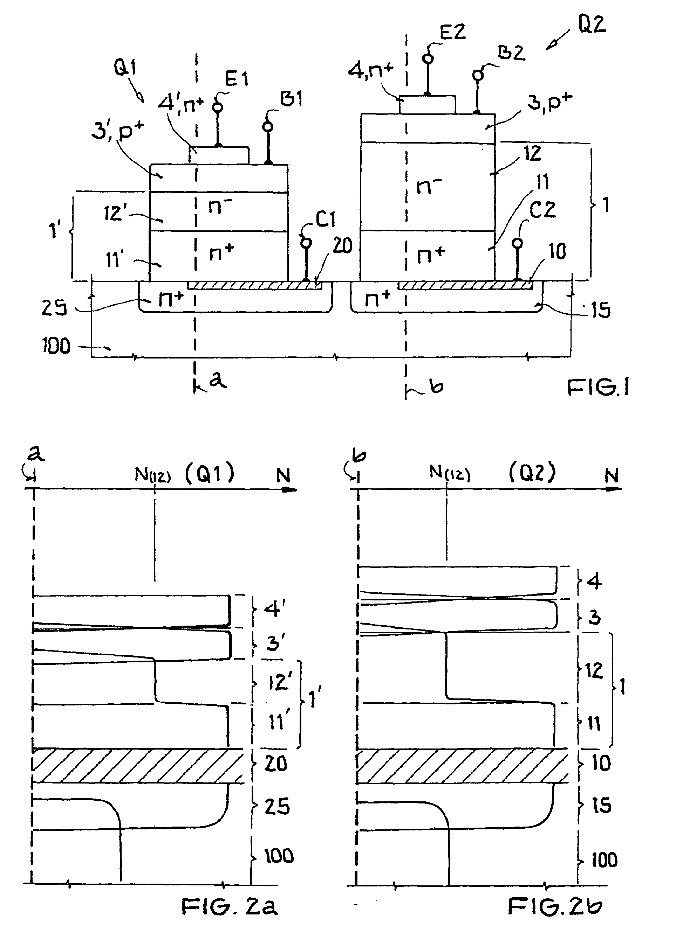

In der Fig. 1 sind zwei Bipolartransistoren Q1 und Q2 dargestellt. Im Folgenden werden beide Transistoren Q1 und Q2 als npn-Bipolartransistoren beschrieben, die in einer integrierten Schaltung vielfach vorkommen können. Die Erfindung ist jedoch durch einfachen Austausch der Leitungstypen auch für pnp-Bipolartransistoren gleichermaßen anwendbar. Die Halbleiterregionen 3' und 4' des ersten, linken Bipolartransistors Q1 der Fig. 1 sind in diesem Ausführungsbeispiel mit den jeweils entsprechenden Halbleiterregionen 3, 4 des zweiten, rechten Bipolartransistors Q2 identisch.

Der erste Transistor Q1 ist durch epitaktische Verfahren auf einem Substrat 100 erzeugt. Hierzu ist für einen niederohmigen Anschluss des Kollektors C1 eine hochdotierte Wanne 25 (8e19 cm⁻³) in das p-dotierte Substrat eingebracht und eine Silizidschicht 20 ausgebildet. Oberhalb der Silizidschicht 20 wird eine Kollektorepitaxieschicht 1' monokristallin beispielsweise durch Festphasenepitaxie von beispielsweise 70 nm Dicke aufgewachsen. In derselben Epitaxie wird zudem die Kollektorepitaxieschicht 1 des zweiten Kollektorbereichs 1 des zweiten Transistors Q2 aufgewachsen. Auch dieser zweite Kollektorbereich 1 des zweiten Transistors Q2 ist auf einer Silizidschicht 10 monokristallin aufgewachsen, wobei die Silizidschicht 10 wiederum auf einer in das Substrat 100 eingebrachten, hoch n-dotierten Wanne 15 (8e19 cm⁻³) zum Anschluss des Kollektors C2 des zweiten Transistors Q2 aufgebracht ist.

Weiterhin dienen die Silizidschichten 10, 20 als Festkörper-Dotierstoffquellen, mit deren Hilfe im weiteren Verlauf des Herstellungsprozesses in Randbereichen der hoch dotierten Wannen 15, 25 sowie der Kollektor-Epitaxieschichten 1, 1', die an die Silizidschichten 10, 20 angrenzen, eine Dotierstoffkonzentration von vorzugsweise mehr als 1e20 cm⁻³ durch Ausdiffusion erzeugt wird.

Der Kollektorbereich 1' des ersten Transistors Q1 ist dabei von dem Kollektorbereich 1 des zweiten Transistors Q2 verschieden. Der Kollektorbereich 1' des ersten Transistors Q1 weist einen ersten, hochdotierten Halbleiterbereich 11' und einen zweiten, niederdotierten Halbleiterbereich 12' auf. Der erste Halbleiterbereich 11 des zweiten Transistors Q2 weist ebenfalls eine hohe Dotierstoffkonzentration N(12') und dieselbe Dicke wie der erste Halbleiterbereich 11' des ersten Transistors Q1 auf. Hingegen ist der zweite Halbleiterbereich 12 des zweiten Transistors Q2 niedriger dotiert und weist eine größere Dicke auf als das der zweite Halbleiterbereich 12' des ersten Transistors Q1. Beispielsweise kann die Dotierstoffkonzentration N(12) im zweiten Halbleiterbereich 12 des zweiten Transistors Q2 2e16 cm⁻³ und die Dicke des zweiten Halbleiterbereichs 12 des zweiten Transistors Q2 200 nm betragen. Die Dotierstoffkonzentration N (12') in dem zweiten Halbleiterbereich 12' des ersten Transistors Q1 liegt jedoch im Bereich von 5e17 cm⁻³ und dessen Dicke beträgt in diesem Ausführungsbeispiel 50nm.

Diese zweiten Halbleiterbereiche 12', 12 grenzen in den Transistoren Q1 und Q2 an die Halbleiterregion 3', 3 (mit einer maximalen Dotierstoffkonzentration von beispielsweise 2e19 cm⁻³) der Basis B1 beziehungsweise B2 des jeweiligen Transistors Q1 beziehungsweise Q2. Die Basis-Halbleiterregion 3', 3 weist dabei vorzugsweise eine Silizium-Germanium-Schicht auf. Wiederum an die Basis-Halbleiterregion 3', 3 grenzt die Halbleiterregion 4', 4 des Emitters E1 beziehungsweise E2 des jeweiligen Transistors Q1 beziehungsweise Q2. Die Dotierstoffkonzentration in der Halbleiterregion 4', 4 beträgt im Grenzbereich zur Basis beispielsweise etwa 2e18 cm⁻³ und außerhalb des Grenzbereichs etwa 2e20 cm⁻³. Dabei sind in diesem Ausführungsbeispiel der Erfindung die Kollektorbereiche 1 bzw. 1' und die Emitterschicht 4 bzw. 4' n-dotiert, während die Basisschicht 3, 3' p-dotiert ist.

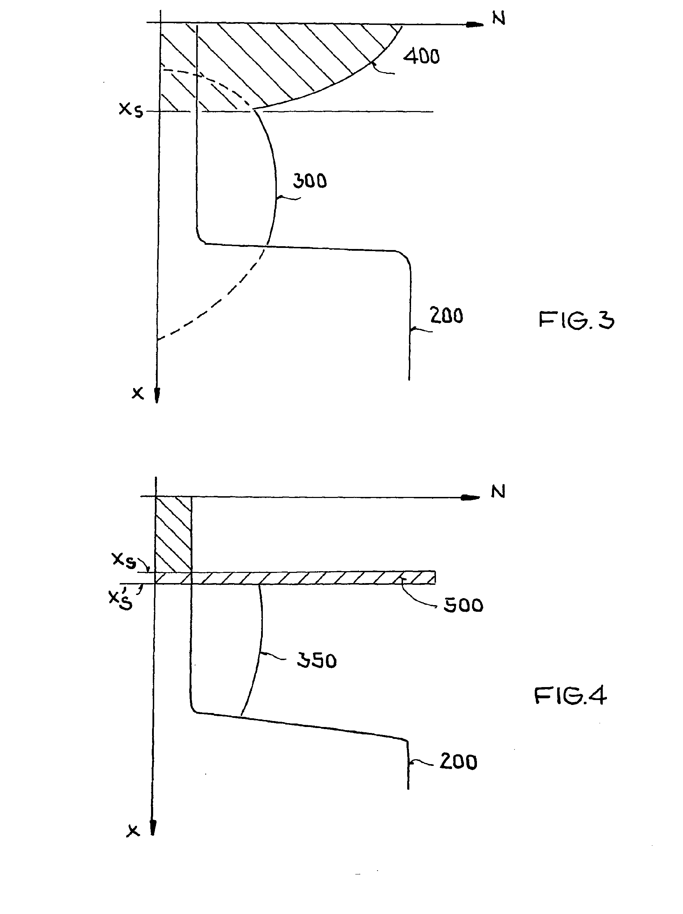

Der Unterschied zwischen den Transistoren Q1 und Q2 ist ausschließlich durch die unterschiedlichen Kollektorbereiche 1 und 1' insbesondere mit den Halbleiterbereichen 12' und 12 gegeben. Dies wird nachfolgend anhand der Dotierstoffverläufe N(Q1) und N(Q2) entlang der Schnitte a und b erläutert. Dabei verläuft der Schnitt a durch den ersten Bipolartransistor Q1, dargestellt in der Fig. 2a und der Schnitt b durch den zweiten Bipolartransistor Q2, dargestellt in der Fig. 2b.

Fig. 2a zeigt, dass der Kollektorbereich 1' des ersten Transistors Q1 durch eine Epitaxieschicht gebildet ist, wobei der erste Halbleiterbereich 11' der Epitaxieschicht in situ hoch n⁺-dotiert ist und einen quasimetallischen Anschluss des zweiten Halbleiterbereichs 12' ermöglicht. Der zweite Halbleiterbereich 12' des ersten Transistors Q1 (Fig. 2a), der als Kollektordriftzone wirkt, ist dabei gegenüber dem zweiten Halbleiterbereich 12, wie in der Fig. 2b dargestellt, verkürzt und weist zudem eine höhere Dotierstoffkonzentration N(12') auf. Durch diese Maßnahmen ist der erste Transistor Q1 für Hochfrequenzanwendungen optimiert und weist eine gegenüber dem Transistor Q2 höhere Transitfrequenz und eine geringere Durchbruchsspannung auf.

Zur Verkürzung des zweiten Halbleiterbereichs 12' ist im Herstellungsverfahren ein Schritt zur Materialabtragung vorgesehen. Hierzu ist, wie in den folgenden Figuren 3 und 4 dargestellt, ein Ätzstopp vorgesehen, der eine Materialätzung in die Tiefe x der Epitaxieschicht des ersten Halbleiterbereichs 12' des ersten Transistors Q1 begrenzt.

Fig. 3 zeigt einen Dotierstoffverlauf zu einem Ausführungsbeispiel der Erfindung vor dem Ätzschritt. Der Verlauf 200 der Dotierung der Epitaxie weist einen steilen Konzentrationsgradienten auf, der während der Epitaxie erzeugt worden ist. Im niederdotierten Bereich der Epitaxiedotierung 200 sind zwei weitere Dotierprofile 300 und 400, die durch zwei unterschiedliche Implantationen erzeugt wurden, maßgeblich.

Das Implantations-Dotierstoffprofil 300 der ersten Implantation ist durch eine höhere lmplantationsenergie erzeugt worden als das zweite Implantations-Dotierstoffprofil 400, das eine Oberfläche nnahe maximale Dotierstoffkonzentration aufweist und erst in der Tiefe xₛ auf die Dotierstoffkonzentration des ersten Implantations-Dotierstoffprofil 300 absinkt. Die hohe Dotierstoffkonzentration des zweiten lmplantations-Dotierstoffprofils 400 ermöglicht ein selektives Ätzen dieses hochdotierten Bereichs bis zur Tiefe xₛ, wobei die niedrige Dotierstoffkonzentration an der Stelle xₛ als Ätzstopp wirkt. In diesem Ausführungsbeispiel erfolgt der selektive Abtrag der hochdotierten Halbleitergebietes durch Behandeln mit einer Mischung aus einem Teil Flusssäure, HF, drei Teilen Salpetersäure, HNO₃ und acht Teilen Ameisensäure, CH₃COOH, vorzugsweise, solange die die Implantation der Profile 300, 400 strukturierende Maske den Wafer noch bedeckt.

Fig. 4 zeigt ein anderes Ausführungsbeispiel der Erfindung, indem eine Silizium-Germanium-Schicht 500 als Ätzstopp wirkt. Die Silizium-Germanium-Schicht 500 ist dabei in situ während der Epitaxie zur Erzeugung des Epitaxiedotierstoffprofils 200 eingebracht worden. Zur Ätzung wird ein Ätzmittel verwendet, dass eine geringere Ätzrate gegenüber der Silizium-Germanium-Schicht aufweist, so dass die Ätzung in der Tiefe xₛ zum Stillstand kommt. Vorzugsweise vor dem Ätzabtrag wird das Dotierstoffprofil 350 implantiert, wobei der Leitungstyp dem der Epitaxieschicht entspricht. Nachfolgend wird auch die Silizium-Germanium-Schicht durch Ätzung entfernt. Während dieser Ätzungen gemäß der Figuren 3 oder 4 wird der zweite Transistor Q2 durch eine Maske abgedeckt und vor dem Ätzmittel geschützt. Hierzu kann vorteilhafterweise die die Implantation des Dotierstoffprofils 350 strukturierende Maske dienen, wobei diese Maske nach dem Ätzschritt entfernt wird. In dieser Ausführungsform erfolgt der selektive Abtrag der epitaktisch aufgebrachten Siliziumschicht bis zur Silizium-Germanium-Ätzstoppschicht 500 durch teilweises Abdecken des Wafers mit einer Maske und anschließendem Behandeln mit KOH.

## Patentansprüche

1. Verfahren zur Herstellung einer integrierten Schaltung auf einem Halbleiterplättchen, wobei
- ein erster Bipolartransistor (Q1) mit einem ersten Kollektorbereich (1') eines ersten Leitungstyps und
- ein zweiter Bipolartransistor (Q2) mit einem zweiten Kollektorbereich (1) dieses ersten Leitungstyps erzeugt werden,
indem
- der erste Kollektorbereich (1') und der zweite Kollektorbereich (1) durch zumindest eine Kollektorepitaxie aufgewachsen werden,
- in den ersten Kollektorbereich (1') ein Ätzstopp eingebracht wird, und
- durch eine Ätzung dieser erste Kollektorbereich (1') verkürzt wird.

2. Verfahren nach Anspruch 1, **dadurch gekennzeichnet, dass** der Ätzstopp durch ein Dotierungsprofil (400, 300) in den ersten Kollektorbereich (1') selektiv eingebracht wird.

3. Verfahren nach Anspruch 2, **dadurch gekennzeichnet, dass** zum selektiven Einbringen des Dotierungsprofils (400, 300) eine Maske aufgebracht und Dotanden implantiert werden.

4. Verfahren nach Anspruch 3, **dadurch gekennzeichnet, dass** in den ersten Kollektorbereich (1') ein Dotierungsprofil (400, 300) derart eingebracht wird, dass ein erstes Halbleitergebiet im ersten Kollektorbereich (1') eine erste Dotierstoffkonzentration (300) und ein oberhalb des ersten Halbleitergebiets gelegenes zweites Halbleitergebiet des ersten Kollektorbereichs (1') eine zweite Dotierstoffkonzentration (400) aufweist, wobei die zweite Dotierstoffkonzentration (400) im zweiten Halbleitergebiet höher ist als die erste Dotierstoffkonzentration (300) im ersten Halbleitergebiet.

5. Verfahren nach Anspruch 4, **dadurch gekennzeichnet, dass** das zweite Halbleitergebiet durch ein selektiv auf das hochdotierte zweite Halbleitergebiet wirkendes Ätzmittel im Wesentlichen bis zum ersten Halbleitergebiet geätzt wird, wobei die niedrige, erste Dotierstoffkonzentration (300) des ersten Halbleitergebiets als Ätzstopp wirkt.

6. Verfahren nach einem der Ansprüche 4 oder 5, **dadurch gekennzeichnet, dass** nach dem Ätzen des zweiten Halbleitergebietes in das erste Halbleitergebiet Dotanden implantiert werden.

7. Verfahren nach einem der Ansprüche 4 oder 5, **dadurch gekennzeichnet, dass** vor dem Ätzen des zweiten Halbleitergebietes in das erste Halbleitergebiet Dotanden implantiert werden.

8. Verfahren zumindest nach Anspruch 1, **dadurch gekennzeichnet, dass** während der Kollektorepitaxie eine Silizium-Germanium-Schicht (500) eingebracht wird.

9. Verfahren nach Anspruch 6, **dadurch gekennzeichnet, dass** der erste Kollektorbereich (1') bis zur Silizium-Germanium-Schicht (500) geätzt wird, indem für das verwendete Ätzmittel die Silizium-Germanium-Schicht (500) als Ätzstopp wirkt.

10. Verfahren nach Anspruch 9, **dadurch gekennzeichnet, dass** nach dem Erreichen der Silizium-Germanium-Schicht (500) diese Silizium-Germanium-Schicht (500) im ersten Kollektorbereich (1') entfernt wird.

11. Verfahren nach einem der vorhergehenden Ansprüche, **dadurch gekennzeichnet, dass** während der Kollektorepitaxie im ersten Kollektorbereich (1') und/oder im zweiten Kollektorbereich (1) ein Dotierstoffkonzentrationsverlauf mit einem Konzentrationsgradienten größer 1 e22 cm⁻⁴ erzeugt wird.

12. Verfahren nach einem der vorhergehenden Ansprüche, **dadurch gekennzeichnet, dass** eine minimale Dotierstoffkonzentration (N(12')) im ersten Kollektorbereich (1') höher ist als die minimale Dotierstoffkonzentration (N(12)) im zweiten Kollektorbereich (1).

13. Verfahren nach einem der vorhergehenden Ansprüche, **dadurch gekennzeichnet, dass** die Kollektorepitaxie eine laterale Festphasenepitaxie aufweist, wobei amorphes Silizium auf einer Silizidschicht (10, 20) und auf ein monokristallines Siliziumsubstrat (100) aufgebracht und in einem Temperschritt ausgehend von dem als Kristallisationskeim wirkenden monokristallinem Siliziumsubstrat (100) auskristallisiert wird.

14. Integrierte Schaltung auf einem Halbleiterplättchen, mit
- einem ersten Bipolartransistor (Q1) und
- einem zweiten Bipolartransistor (Q2),
wobei
- der erste Bipolartransistor (Q1) einen ersten, durch zumindest eine Epitaxieschicht aufgewachsenen Kollektorbereich (1') eines ersten Leitungstyps aufweist, und
- der zweite Bipolartransistor (Q2) einen zweiten, durch diese Epitaxieschicht aufgewachsenen zweiten Kollektorbereich (1) dieses ersten Leitungstyps aufweist,
- der erste Kollektorbereich (1') eine erste Kollektordriftzone (12') und der zweite Kollektorbereich (1) eine zweite Kollektordriftzone (12) aufweist, und
- diese erste Kollektordriftzone (12') gegenüber dieser zweiten Kollektordriftzone (12) durch teilweises Ätzen der Epitaxieschicht verkürzt ist.

15. Integrierte Schaltung nach Anspruch 14, **dadurch gekennzeichnet, dass** der erste Kollektorbereich (1') eine höhere minimale Dotierstoffkonzentration (N(12')) aufweist als der zweite Kollektorbereich (1).

16. Integrierte Schaltung nach einem der Ansprüche 14 oder 15, **dadurch gekennzeichnet, dass** der erste Kollektorbereich (1') unmittelbar an eine Silizium-Germanium-Schicht eines ersten Basisbereiches (3') eines zweiten Leitungstyps des ersten Bipolartransistors (Q1) grenzt und/oder der zweite Kollektorbereich (1) unmittelbar an eine Silizium-Germanium-Schicht eines zweiten Basisbereiches (3) des zweiten Leitungstyps des zweiten Bipolartransistors (Q2) grenzt.

17. Integrierte Schaltung nach einem der vorhergehenden Ansprüche, **dadurch gekennzeichnet, dass** innerhalb des ersten Kollektorbereichs (1') und/oder innerhalb des zweiten Kollektorbereichs (1) die Epitaxieschicht zumindest teilweise an eine Silizidschicht (10, 20) angrenzt.

18. Integrierte Schaltung nach einem der vorhergehenden Ansprüche, **dadurch gekennzeichnet, dass** der erste Kollektorbereich (1') und/oder der zweite Kollektorbereich (1) einen Dotierstoffkonzentrationsverlauf (200, 300, 350) mit einem Konzentrationsgradienten größer als 1 e22 cm⁻⁴ aufweist.

19. Integrierte Hochfrequenz-Kaskodenschaltung mit
- einem ersten Bipolartransistor (Q1) und
- einem zweiten Bipolartransistor (Q2),
wobei
- der erste Bipolartransistor (Q1) einen ersten, durch zumindest eine Epitaxieschicht aufgewachsenen Kollektorbereich (1') eines ersten Leitungstyps aufweist, und
- der zweite Bipolartransistor (Q2) einen zweiten, durch diese Epitaxieschicht aufgewachsenen zweiten Kollektorbereich (1) dieses ersten Leitungstyps aufweist,
- der erste Kollektorbereich (1') eine erste Kollektordriftzone (12') und der zweite Kollektorbereich (1) eine zweite Kollektordriftzone (12) aufweist,
- diese erste Kollektordriftzone (12') gegenüber dieser zweiten Kollektordriftzone (12) durch teilweises Ätzen der Epitaxieschicht verkürzt ist, und
- der zweite Kollektorbereich (1) des zweiten Bipolartransistors (Q2) mit einem ersten Emitterbereich (4') des ersten Bipolartransistors (Q1) elektrisch verbunden ist.
